# EUROPEAN PATENT SPECIFICATION

(11) **EP 0 460 050 B1**
(45) Date of publication and mention of the grant of the patent: **12.05.1993**
(21) Application number: 90903988.5
(22) Date of filing: 05.02.1990
(51) Int. Cl.: G01R 31/02

(54) **A METHOD FOR TESTING THE OPERATIONAL EFFICIENCY OF A COMPONENT OF AN ELECTRONIC CIRCUIT**
VERFAHREN ZUR PRÜFUNG DER BETRIEBSEFFIZIENZ VON KOMPONENTEN ELEKTRONISCHER SCHALTUNGEN
PROCEDE DE TEST DU RENDEMENT OPERATIONNEL D'UN COMPOSANT D'UN CIRCUIT ELECTRONIQUE

(30) Priority: 27.02.1989 SE 8900673
(43) Date of publication of application: 11.12.1991
(73) Proprietor: AGA AKTIEBOLAG, 181 81 Lidingö (SE)
(72) Inventor: ÖHRSTRÖM, Per, S-162 45 Vällingby (SE); NORL N, Sten, S-731 21 Köping (SE)
(74) Representative: Wiedemann, Bernd
(86) International application number: SE9000071
(87) International publication number: WO9010240

(56) References cited:
- DE-A- 3 440 896
- US-A- 4 757 255
- Derwent's abstracts No. 466 41 C/25, SU 695 777, publ. week 8025

## Description

The present invention relates to a method for testing the operational efficiency of a component of an electronic circuit at low temperature, comprising the steps of chilling the component and/or its connections to the remainder of the circuit and measuring the operational functioning of the component in the circuit or the operational functioning of the component together with the functioning of its electrical connections or solely measuring the operational functioning of the electrical connections.

Malfunctions which are difficult to detect are not unusual in electronic circuits. This is particularly true in the case of malfunctions which are due to variations in ambient temperature. One example of faults which lead to such malfunctions is so-called cold welds, where the circuit will operate correctly under certain conditions and will malfunction under others. For instance, at room temperature two cold-welded ends may be in contact with one another such as to provide a sufficiently effective conductor path for the circuit to function. When such a weld is exposed to low temperatures, for instance in the region of -50°C, contraction will occur and the aforesaid ends will become spaced apart to such an extent as to impair conduction of electric current therebetween. The break in the conductor path can be readily detected at this low temperature.

In other instances, it is desirable to replace a circuit component and to test the function of the component at low temperatures. In these and similar circumstances, it has been normal to spray the circuit or the component connection with liquid freon and then test the functioning of the component in operation. The freon vaporises while chilling the component and is taken up by the surrounding atmosphere.

The negative effect which freon has on the atmospheric ozone layer has become more and more apparent in recent years. This has lead to regulations which are intended to result in a reduction in the use of freon.

DE-A1-34 40 896 discloses a means for heating or cooling integrated electronic circuits. This heating or cooling of the components is performed with hollow bars, through which warm or cold gas is made to flow. The heat transfer to the components is due to thermal conduction, giving short heating and cooling time, respectively. The gas flowing through the bar gives essentially constant temperature along the bar. As a cooling gas nitrogen is given as an example.

One object of the present invention is to find a substitute for freon in the detection of temperature-dependent disturbances in the functioning of electronic circuits.

Another object of the invention is to provide an inexpensive substitute which will not have a harmful effect on the surroundings.

These objects are achieved with a method for testing the operational efficiency of a component of an electronic circuit at low temperature which comprises the steps of chilling the component and/or its connections to the remainder of the circuit and measuring the operational functioning of the component in the circuit or the operational functioning of the component together with the functioning of its connections or solely measuring the operational functioning of the connections, and which further comprises applying solid carbon dioxide to the component and/or to the circuit- connections thereof, the carbon dioxide vaporizing while chilling the component and/or its circuit connections at the same time, and by applying the carbon dioxide with the aid of a nozzle, said carbon dioxide when leaving the nozzle being converted from a liquid carbon dioxide to the carbon dioxide in the solid state, and the nozzle being of an electrically insulated material or of an anti-static material, said nozzle having a diameter of 0.1 to 0.9 mm, preferably a diameter of 0.1 to 0.4 mm.

Condensed carbon dioxide boils at about -78°C. Consequently, when carbon dioxide is stored in a pressure vessel, there is obtained a liquid and a gas phase at normal room temperature. It is therefore necessary to tap from the vessel carbon dioxide in its liquid state and consequently the orifice of the tapping conduit must be located in that part of the vessel in which the carbon dioxide is present in its liquid state. This tapping of the liquid carbon dioxide is controlled with the aid of a conventionally manually-operated valve and the carbon dioxide is delivered to a nozzle of relatively small diameter in the order of 0.1 to 0.9 mm, preferably in the order of 0.1 to 0.4 mm. When the liquid carbon dioxide leaves the nozzle, it converts to solid carbon dioxide ice, which vaporizes.

The nozzle consists of an electrically insulating material or of an anti-static material, so that unintentional contact of the nozzle with the circuit will not result in a short-circuit.

According to one preferred embodiment of the invention the nozzle has the form of a hose with the aforesaid internal diameter and the hose-material has an electrical conductivity of from 2 to 100 megaohm per meter. This enables static electricity which forms when the carbon dioxide is sprayed to be led away.

## Claims

1. A method of testing the operational efficiency of a component of an electronic circuit at low temperature, comprising the steps of chilling the component and/or its connections to the remainder of the circuit and measuring the operational function of the component in the circuit together with the functioning of its circuit connections, **characterized** by applying carbon dioxide in a solid state to the component and/or the component connections, wherewith the carbon dioxide vaporizes while chilling the component and/or said connections at the same time, and by applying the carbon dioxide with the aid of a nozzle, said carbon dioxide when leaving the nozzle being converted from a liquid carbon dioxide to the carbon dioxide in the solid state, and the nozzle being of an electrically insulated material or of an anti-static material, said nozzle having a diameter of 0.1 to 0.9 mm, preferably a diameter of 0.1 to 0.4 mm.

## Patentansprüche

1. Verfahren zum Testen der betrieblichen Leistungsfähigkeit der Komponente einer elektronischen Schaltung bei niedriger Temperatur, die die Schritte des Kühlens der Komponente und/oder ihrer Verbindungen mit der übrigen Schaltung und des Messens der betrieblichen Leistungsfähigkeit der Komponente in der Schaltung zusammen mit der Funktion ihrer Schaltungsverbindungen umfaßt, dadurch gekennzeichnet, daß Kohlendioxid in festem Zustand auf die Komponente und/oder die Komponentenverbindungen aufgebracht wird, wobei das Kohlendioxid unter gleichzeitiger Kühlung der Komponente und/oder der besagten Verbindungen verdampft, und daß das Kohlendioxid mit Hilfe einer Düse aufgebracht wird, wobei das Kohlendioxid beim Verlassen der Düse vom Zustand flüssigen Kohlendioxids zu Kohlendioxid in festem Zustand umgewandelt wird, und daß die Düse aus elektrisch isoliertem Material oder einem Antistatik-Material besteht und einen Durchmesser von 0,1-0,9mm, vorzugsweise einen Durchmesser von 0,1-0,4mm hat.

## Revendications

1. Un procédé d'essai du rendement opérationnel, à basse température, d'un composant d'un circuit électronique comprenant les étapes consistant à refroidir le composant et/ou ses connexions au reste du circuit et mesurer le fonctionnement opérationnel du composant dans le circuit en même temps que le fonctionnement de ses connexions de circuit, caractérisé en ce que du dioxyde de carbone est appliqué à l'état solide sur le composant et/ou les connexions du composant, de sorte que le dioxyde de carbone s'évapore en refroidissant en même temps le composant et/ou ledites connexions, et en ce que le dioxyde de carbone est appliqué à l'aide d'une tuyère, ledit dioxyde de carbone étant converti d'un dioxyde de carbone liquide au dioxyde de carbone à l'état solide lorsqu'il quitte la tuyère, et la tuyère étant en une matière isolée électriquement ou en une matière antistatique, le diamètre de ladite tuyère étant compris entre 0,1 et 0,9 mm, de préférence entre 0,1 et 0,4 mm.
